# FASCICULE DE BREVET EUROPEEN

(11) **EP 0 926 338 B1**
(45) Date de publication et mention de la délivrance du brevet: **13.08.2003**
(21) Numéro de dépôt: 98403207.8
(22) Date de dépôt: 18.12.1998
(51) Int. Cl.: F02P 17/12, G01N 27/62

(54) **Dispositif de mesure du courant d'ionisation dans une chambre de combustion**
Gerät zur Messung des Ionisationsstromes einer Brennkammer
Device for measuring the ionisation current in a combustion chamber

(30) Priorité: 19.12.1997 FR 9716128
(43) Date de publication de la demande: 30.06.1999
(73) Titulaire: Renault s.a.s., 92100 Boulogne Billancourt (FR)
(72) Inventeur: Agache-Durand, Miréla, 75006 Paris (FR); Agneray, André, 92100 Boulogne Billancourt (FR)

(56) Documents cités:
- EP-A- 0 627 622
- US-A- 5 180 983
- US-A- 5 271 268

## Description

La présente invention concerne un dispositif de mesure du courant d'ionisation dans une chambre de combustion.

Il est connu de caractériser la qualité des combustions survenant dans les chambres de combustion des moteurs à combustion interne par la mesure d'un courant dit d'ionisation. En effet, la cinétique chimique de la combustion d'un mélange carburé air-essence produit majoritairement des radicaux électriquement neutres. Elle produit également une faible quantité d'ions comme les ions OH⁻. Ces espèces ioniques engendrées par la combustion ont une durée de vie suffisante pour rendre conducteur les gaz de combustion. Grâce à des électrodes débouchant dans la chambre de combustion et maintenues à des potentiels électriques différents, il est donc possible d'observer un courant électrique dit d'ionisation circulant entre les électrodes.

De tels dispositifs de détection du courant d'ionisation sont décrits dans les documents JP 129534/93 et JP 129796/93. Ces documents divulguent des modes de réalisation d'un détecteur, mais ne précisent pas de quelle manière la mesure doit être faite pour offrir la qualité la meilleure.

La présente invention a donc pour objet un dispositif de mesure du courant d'ionisation qui améliore les performances des dispositifs connus à ce jour, en offrant une excellente sensibilité de mesure et limitant les perturbations engendrées par les étincelles d'allumage.

Le dispositif de mesure du courant d'ionisation dans une chambre de combustion de moteur à combustion interne à allumage commandé selon l'invention est du type comportant une bougie d'allumage présentant une électrode centrale reliée à des moyens d'alimentation électrique et insérée dans un culot par l'intermédiaire d'un isolateur, et au moins une antenne débouchant dans la chambre au voisinage de la bougie, cette antenne coopérant avec des moyens de mesure et des moyens de polarisation.

Selon l'invention, le dispositif de mesure du courant d'ionisation dans une chambre de combustion est caractérisé en ce que les moyens de polarisation de l'antenne sont conformés pour polariser cette dernière à un potentiel électrique positif adapté, de manière à recueillir le courant engendré par les espèces ionisées négatives présentes dans la chambre de combustion et générées par la combustion du mélange carburé initiée par le déclenchement d'un arc électrique entre l'électrode centrale et le culot de la bougie.

Selon un premier mode de réalisation du dispositif de mesure du courant d'ionisation dans une chambre de combustion objet de l'invention, les moyens d'alimentation électrique de l'électrode centrale de la bougie sont conformés pour polariser négativement ladite électrode centrale.

Selon une autre caractéristique de ce premier mode de réalisation du dispositif de mesure du courant d'ionisation dans une chambre de combustion objet de l'invention, les moyens de polarisation de l'antenne sont conformés pour polariser cette dernière à un potentiel électrique positif de quelques dizaines de volts.

Selon un second mode de réalisation du dispositif de mesure du courant d'ionisation dans une chambre de combustion objet de l'invention, les moyens d'alimentation électrique de l'électrode centrale de la bougie sont conformés pour polariser positivement ladite électrode centrale.

Selon une autre caractéristique du dispositif de mesure du courant d'ionisation dans une chambre de combustion objet de l'invention, les moyens de polarisation de l'antenne sont conformés pour polariser l'antenne à un potentiel électrique positif sensiblement supérieur à celui sensiblement stable de l'électrode centrale de la bougie suivant le pic d'amorçage de l'arc électrique.

Selon une autre caractéristique du dispositif de mesure du courant d'ionisation dans une chambre de combustion objet de l'invention, les moyens d'alimentation électrique de l'électrode centrale de la bougie sont conformés pour continuer à polariser ladite électrode après la fin de l'arc électrique.

Selon une autre caractéristique du dispositif de mesure du courant d'ionisation dans une chambre de combustion objet de l'invention, les moyens d'alimentation électrique de l'électrode centrale de la bougie sont conformés pour contrôler la durée de l'arc électrique.

On comprendra mieux les buts, aspects et avantages de la présente invention, d'après la description donnée ci-après de modes de réalisation de l'invention, ces modes étant présentés à titre d'exemples non limitatifs en se référant aux dessins annexés, dans lesquels :
la figure 1 représente en coupe axiale une bougie d'allumage implantée dans la culasse d'un moteur à combustion interne selon le dispositif objet de l'invention ;
la figure 2 représente en coupe axiale une vue de détail du voisinage du point d'allumage de la bougie représentée à la figure 1, précisant la répartition des charges électriques en présence de l'étincelle d'allumage ;
la figure 3 est une vue similaire à la figure 2 précisant la répartition des charges électriques une fois l'étincelle d'allumage terminée ;
la figure 4a est un chronogramme montrant l'évolution des potentiels dans divers éléments du dispositif dans le cas d'une polarisation négative de la bougie ;
la figure 4b est une vue similaire à la figure 4a montrant l'évolution des potentiels dans divers éléments du dispositif dans le cas d'une polarisation positive de la bougie ;
la figure 5 représente de façon schématique un circuit électrique de commande de la bougie selon une variante du dispositif objet de l'invention ;
les figures 6a et 6b sont des vues similaires aux figures 4a et 4b dans le cas de la variante du dispositif objet de la figure 5.

Conformément aux figures, seuls les éléments indispensables à la compréhension de l'invention ont été figurés. Par ailleurs, pour faciliter la lecture des dessins, les mêmes éléments portent les mêmes références d'une figure à l'autre.

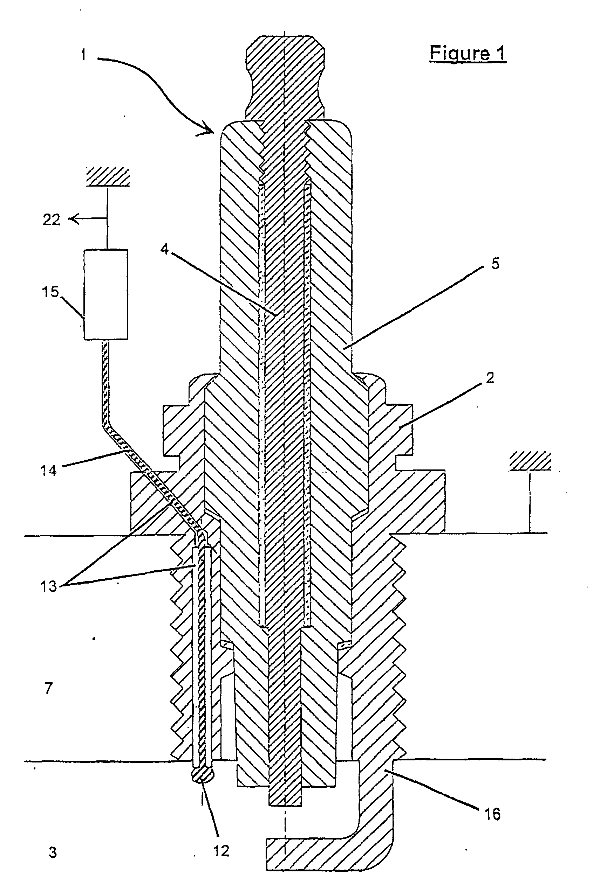

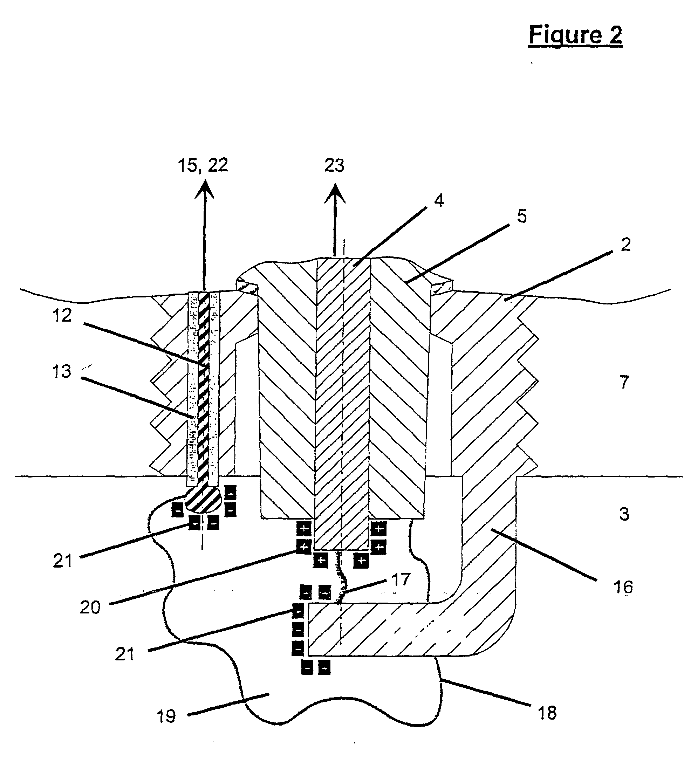

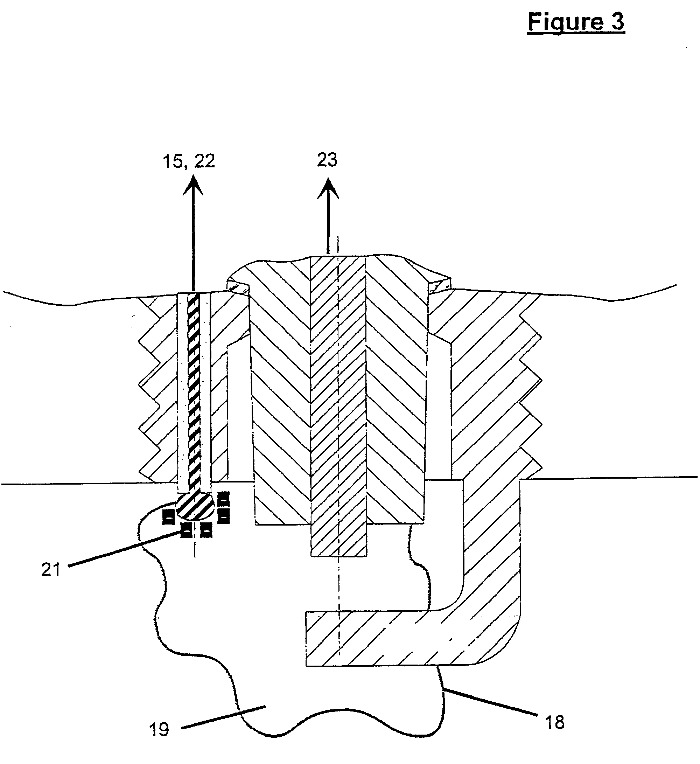

En se reportant sur les figures 1 à 3, on voit une bougie d'allumage 1 en position dans la culasse 7 d'un moteur à combustion interne pour déboucher dans une chambre de combustion 3.

Cette bougie 1 est classiquement constituée d'un culot 2, d'un isolateur électrique 5, et d'une électrode centrale 4. L'électrode centrale 4 est reliée à des moyens 23 permettant la génération, à un instant prédéterminé, d'un arc électrique 17 entre l'électrode centrale 4 et un point du culot 2, par exemple une tige 16.

Une antenne 12, faite d'un matériau conducteur de l'électricité, est implantée dans le culot 2 et reliée à un appareillage de mesure 15 par l'intermédiaire d'un câble 14. Une source de tension 22 assure la polarisation de l'antenne 12 par rapport au culot 2 et à la culasse 7. Un manchon isolant 13 en céramique à base d'alumine, assure l'isolation électrique de l'antenne 12 par rapport à tout l'environnement excepté donc la chambre de combustion 3, l'appareillage de mesure 15, et les moyens de polarisation 22.

Au moment de l'allumage, la différence de potentiel engendrée par les moyens 23 entre l'électrode centrale 4 et le culot 2 atteint un pic de valeur absolue très élevée (d'environ dix mille volts) pendant le bref intervalle nécessaire à l'établissement de l'arc électrique 17, puis retombe à une valeur plus modeste (de quelques centaines de volts en valeur absolue) où elle se stabilise pendant le reste de la durée de l'arc 17. Lorsque l'arc 17 disparaît la tension entre les bornes de la bougie tend ensuite rapidement vers 0 V.

Après l'allumage, la combustion du mélange carburé présent dans la chambre 3 se propage sur un front de flamme 18 qui entoure une région de gaz brûlés 19. Ceux-ci contiennent, au voisinage immédiat du front de flamme 18, de nombreux produits intermédiaires des réactions chimiques de combustion, en particulier des espèces chargées positivement 20 et des espèces chargées négativement 21.

Du fait de l'existence d'une différence de potentiel entre l'antenne 12 polarisée par les moyens 22 et les gaz de combustion 19, l'antenne 12 capte donc l'une de ces deux sortes d'espèces ; il s'établit ainsi un courant d'ionisation dont les caractéristiques dépendent de la nature des gaz de combustion et donc de la qualité de la combustion.

L'antenne 12 est selon l'invention, polarisée à un potentiel positif supérieur à ceux du culot 2 et de la culasse 7, de façon à capter les espèces chargées négativement 21, lesquelles, apparaissant plus mobiles que les espèces chargées positivement 20, sont plus aisées à recueillir et garantissent ainsi une excellente sensibilité de mesure.

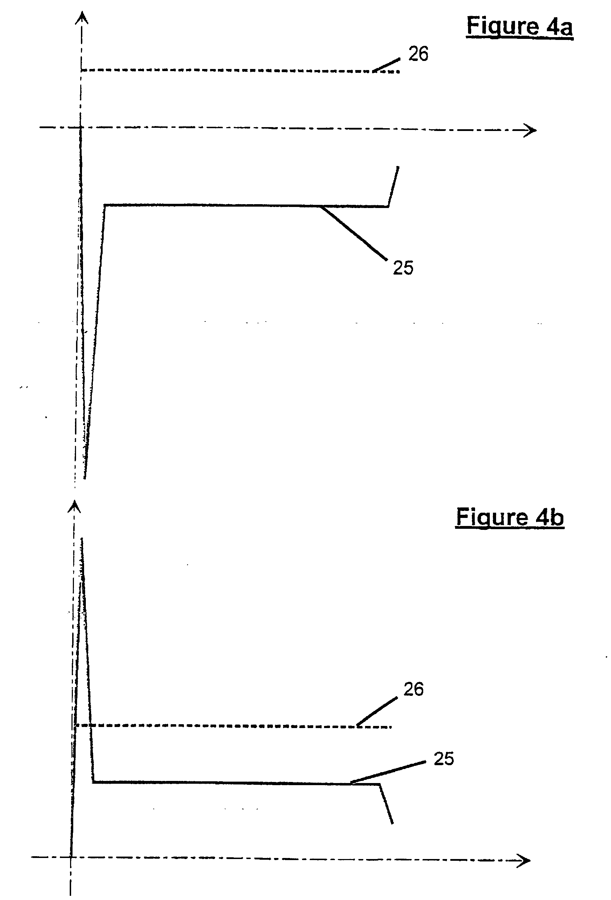

En se reportant à la figure 4a, on a représenté les évolutions dans le temps de la tension de polarisation 26 de l'antenne 12 et de la tension 25 aux bornes des électrodes de la bougie 1 dans le cas où le circuit d'alimentation 23 de la bougie 1 polarise l'électrode centrale 4 négativement vis-à-vis du culot 2 et de la culasse 7.

Dans ce cas là, le simple fait que l'antenne 12 soit polarisée positivement suffit à attirer les espèces chargées négativement 21 dés le contact de l'antenne avec les gaz de combustion et tout au long du déroulement de la combustion, puisque l'antenne 12 est le seul élément à être polarisée positivement.

Le potentiel de polarisation 26 peut donc être choisi à une valeur positive arbitraire, par exemple quelques volts ou quelques dizaines de volts, pour obtenir l'effet désiré de capture des espèces ioniques chargées négativement dès le début de la combustion. Il est même envisageable de ne pas polariser l'antenne 12 par une source externe et la laisser au potentiel flottant.

Le faible niveau de potentiel a appliqué à l'antenne 12 permet donc des montages particulièrement simples.

En se reportant à la figure 4b, on a représenté l'évolution d'une part de la tension de polarisation 26 et d'autre part de la tension 25 aux bornes des électrodes de la bougie 1 dans le cas où le circuit d'alimentation 23 de la bougie 1 polarise l'électrode centrale 4 positivement vis-à-vis du culot 2 et de la culasse 7.

Dans ce cas là, pour attirer les espèces chargées négativement 21 très tôt dans le développement de la combustion c'est-à-dire avant même la fin de l'arc 17, le potentiel de polarisation 22 de l'antenne 12 doit être choisi supérieur au potentiel de l'électrode centrale 4 après le pic d'amorçage de l'arc 17. Cette disposition garantit alors que l'antenne 12 attire les espèces chargées négativement 21 préférentiellement à l'électrode centrale 4.

Le potentiel de polarisation 26 de l'antenne 12 est donc alors choisi à une valeur positive arbitraire d'environ quelques centaines de volts, ce qui complexifie sensiblement le montage par rapport à la solution décrite par rapport à la figure 4a puisque le niveau de tension requis est élevé.

En variante de réalisation et pour améliorer encore la mesure du courant de polarisation, il est apparu intéressant de limiter la durée de l'arc 17 à la seule durée nécessaire à la bonne initiation de combustion. En effet, tant que l'arc 17 existe entre les électrodes de la bougie 1, la tension réelle entre ces bornes n'est pas totalement stabilisée après le pic d'amorçage et il peut survenir des pics secondaires qui perturbent la mesure dans le cas où l'électrode centrale 4 est polarisée positivement. Pour ce faire, il suffit de commander la durée d'allumage de façon adaptée.

Selon une autre variante de réalisation et pour améliorer également le dispositif de mesure du courant de polarisation, il est apparu intéressant, notamment dans le cas de la polarisation négative de l'électrode centrale 1, de contrôler après la fin de l'arc 17 l'évolution de la tension aux bornes des électrodes de la bougie 1.

En effet, la qualité de la mesure du courant d'ionisation est liée à la différence de potentiel entre l'antenne 12 et les gaz de combustion qui se trouvent polarisés par l'électrode centrale 4, donc plus le retour vers 0 V du potentiel de l'électrode 4 est lent et plus il est possible de prolonger dans le temps la mesure du courant d'ionisation sans avoir à utiliser un potentiel de polarisation élevé pour l'antenne 12, voir même à ne pas polariser l'antenne par une source externe et la laisser au potentiel flottant.

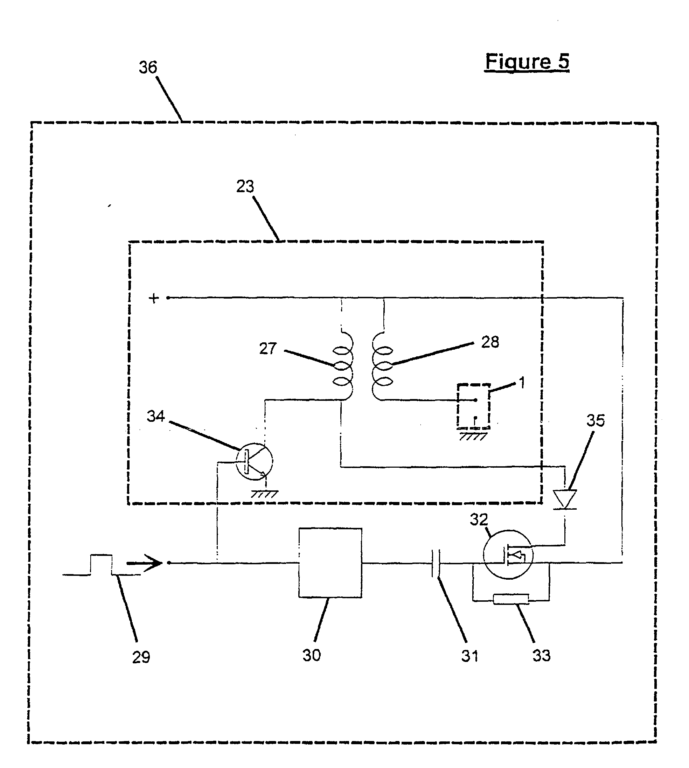

On a détaillé cette variante de réalisation en se reportant à la figure 5. Sur cette figure on a donc représenté un mode de réalisation des moyens 23 de génération d'un arc électrique d'allumage dans la bougie 1 et des moyens 36 de maintien d'une certaine polarisation de l'électrode centrale 4 après la fin de l'arc 17.

L'arc 17 dans la bougie 1 a lieu lorsque le transistor 34, à réception du signal de commande 29, ferme le circuit primaire 27 de la bobine, ce qui engendre un courant sous haute tension dans le secondaire 28 de la bobine. Au même instant, la commande 29, constituée d'un créneau positif de tension, est reçue par un retardateur 30 dont le temps de retard est égal à la durée du signal de commande 29 ajoutée à la durée souhaitée de l'arc 17.

La valeur de ce retard fait qu'immédiatement avant que le retardateur 30 ne transmette la commande 29 au transistor à effet de champ 32, le circuit primaire 27 de la bobine est ouvert, la résistance 33 ayant pour effet de maintenir les bornes du transistor 32 à des potentiels voisins. Lorsque le retardateur 30 transmet la commande 29, le transistor 32, protégé par la diode 35, ferme le circuit primaire 27 de la bobine.

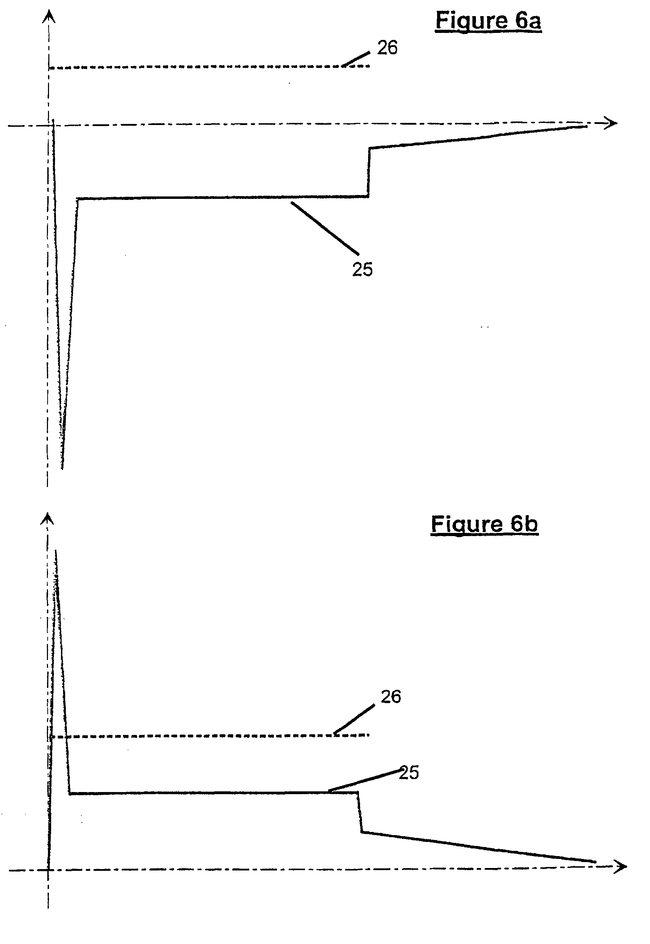

La capacité 31 a pour effet d'ajouter les potentiels du signal de commande 29 et de l'alimentation du primaire 27 de la bobine et de porter le potentiel de la grille du transistor 32 à cette valeur. Le transistor court-circuite le primaire de la bobine 27 présentant à ses bornes un potentiel de l'ordre du volt, ce qui engendre une différence de potentiel dans le secondaire de la bobine 28 d'environ 100 volts, inférieure à celle nécessaire à l'établissement de l'arc 17, et polarise de nouveau l'électrode centrale 4 avec un potentiel évoluant progressivement vers 0 V jusqu'à ce que toute l'énergie électrique présente dans le circuit primaire soit dissipée dans le transistor 32, cf. les figures 6a et 6b.

Conformément au dispositif objet de l'invention, il est possible de mesurer le courant d'ionisation généré dans une chambre de combustion lors de la combustion du mélange carburé par une antenne intégrée à la bougie d'allumage, dès l'arrivée de la flamme sur l'antenne même en présence de l'arc électrique d'allumage.

Bien entendu, l'invention n'est nullement limitée au mode de réalisation décrit et illustré qui n'a été donné qu'à titre d'exemple.

Ainsi, la présente invention peut s'appliquer quel que soit le nombre d'antennes utilisées. Il peut être, en effet, préférable d'utiliser plusieurs antennes pour apprécier plus précisement le déroulement de la combustion.

Ainsi, la ou les antennes utilisées pour mesurer le courant d'ionisation peuvent ne pas être portées par le culot de la bougie d'allumage, la ou les antennes étant par exemple implantées directement à travers la culasse.

## Revendications

1. Dispositif de mesure du courant d'ionisation dans une chambre de combustion (3) de moteur à combustion interne à allumage commandé, du type comportant une bougie d'allumage (1) présentant une électrode centrale (4) reliée à des moyens d'alimentation électrique (23) et insérée dans un culot (2) par l'intermédiaire d'un isolateur (5), et au moins une antenne (12) débouchant dans ladite chambre (3) au voisinage de la bougie (1), ladite antenne (12) coopérant avec des moyens de mesure (15) et des moyens de polarisation (22), **caractérisé en ce que** lesdits moyens de polarisation (22) sont conformés pour polariser ladite antenne (12) à un potentiel électrique (26) positif adapté, de manière à recueillir le courant engendré par les espèces ionisées négatives (21) présentes dans la chambre de combustion (3) et générées par la combustion du mélange carburé initiée par le déclenchement d'un arc électrique (17) entre les électrodes de la bougie (1).

2. Dispositif de mesure du courant d'ionisation dans une chambre de combustion selon la revendication 1, **caractérisé en ce que** les moyens d'alimentation électrique (23) de l'électrode centrale (4) de la bougie (1) sont conformés pour polariser négativement ladite électrode centrale (4).

3. Dispositif de mesure du courant d'ionisation dans une chambre de combustion selon la revendication 2, **caractérisé en ce que** les moyens de polarisation (22) de l'antenne (12) sont conformés pour polariser ladite antenne (12) à un potentiel électrique (26) positif de quelques dizaines de volts.

4. Dispositif de mesure du courant d'ionisation dans une chambre de combustion selon la revendication 1, **caractérisé en ce que** les moyens d'alimentation électrique (23) de l'électrode centrale (4) de la bougie (1) sont conformés pour polarisée positivement ladite électrode centrale (4).

5. Dispositif de mesure du courant d'ionisation dans une chambre de combustion selon la revendication 4, **caractérisé en ce que** les moyens de polarisation (22) de l'antenne (12) sont conformés pour polariser ladite antenne (12) à un potentiel électrique (26) positif sensiblement supérieur à celui sensiblement stable de l'électrode centrale (4) de la bougie (1) suivant le pic d'amorçage de l'arc électrique (17).

6. Dispositif de mesure du courant d'ionisation dans une chambre de combustion selon l'une quelconque des revendications 1 à 5, **caractérisé en ce que** les moyens d'alimentation électrique (23) de l'électrode centrale (4) de la bougie (1) sont conformés pour continuer à polariser ladite électrode (4) après la fin de l'arc électrique (17).

7. Dispositif de mesure du courant d'ionisation dans une chambre de combustion selon l'une quelconque des revendications 1 à 6, **caractérisé en ce que** les moyens d'alimentation électrique (23) de l'électrode centrale (4) de la bougie (1) sont conformés pour contrôler la durée de l'arc électrique (17).

8. Dispositif de mesure du courant d'ionisation dans une chambre de combustion selon la revendication 2, **caractérisé en ce que** l'antenne (12) n'est pas polarisée par une source externe mais laissée au potentiel flottant.

## Patentansprüche

1. Vorrichtung zur Messung des Ionisationsstromes in einer Verbrennungskammer (3) eines Verbrennungsmotors mit gesteuerter Zündung, der eine Zündkerze (1) aufweist mit einer Mittenelektrode (4), die mit einer elektrischen Versorgungsanordnung (23) verbunden ist und unter Zwischenanordnung eines Isolators (5) in ein Kerzengehäuse (2) eingesetzt ist und der wenigstens eine Antenne (12) aufweist, die in der Kammer (3) in der Nähe der Kerze (1) mündet, wobei die Antenne (12) mit einer Anordnung (15) zur Messung und mit einer Anordnung (22) zur Polarisierung zusammenwirkt, **dadurch gekennzeichnet, dass** die Anordnung (22) zur Polarisierung derart ausgelegt ist, dass die Antenne (12) mit einem geeigneten positiven elektrischen Potential (26) derart polarisiert wird, dass sie den Strom aufnimmt, der durch negativ ionisierte Teilchen (21) entsteht, die in der Verbrennungskammer (3) anwesend sind auf Grund der Verbrennung des Kraftstoffgemisches, wobei diese ausgelöst wird durch die Erzeugung eines elektrischen Bogens (17) zwischen den Elektroden der Kerze 1.

2. Vorrichtung zur Messung des Ionisationsstromes in einer Verbrennungskammer nach Anspruch 1, **dadurch gekennzeichnet, dass** die elektrische Versorgungsanordnung (23) für die Mittenelektrode (4) der Kerze (1) derart ausgelegt ist, dass die Mittenelektrode (4) negativ polarisiert wird.

3. Vorrichtung zur Messung des Ionisationsstromes in einer Verbrennungskammer nach Anspruch 2, **dadurch gekennzeichnet, dass** die Anordnung (22) zur Polarisierung der Antenne (12) derart ausgelegt ist, dass die Antenne (12) mit einem positiven elektrischen Potential von einigen zehn Volt beaufschlagt wird.

4. Vorrichtung zur Messung des Ionisationsstromes in einer Verbrennungskammer nach Anspruch 1, **dadurch gekennzeichnet, dass** die elektrische Versorgungsanordnung (23) für die Mittenelektrode (4) der Kerze (1) derart ausgelegt ist, dass die Mittenelektrode (4) positiv polarisiert wird.

5. Vorrichtung zur Messung des Ionisationsstromes in einer Verbrennungskammer nach Anspruch 4, **dadurch gekennzeichnet, dass** die Anordnung (22) zur Polarisierung der Antenne (12) derart ausgelegt ist, dass die Antenne (12) mit einem positiven elektrischen Potential (26) beaufschlagt wird, das größer ist als das im wesentlichen stabile der Mittenelektrode (4) der Kerze (1), das dem Zündungspeak für den elektrischen Bogen (7) folgt.

6. Vorrichtung zur Messung des Ionisationsstromes in einer Verbrennungskammer nach einem der Ansprüche 1 bis 5, **dadurch gekennzeichnet, dass** die elektrische Versorgungsanordnung (23) für die Mittenelektrode (4) der Kerze (1) derart ausgelegt ist, dass die Polarisierung der Elektrode (4) nach Beendigung des elektrischen Bogens (17) beibehalten wird.

7. Vorrichtung zur Messung des Ionisationsstromes in einer Verbrennungskammer nach einem der Ansprüche 1 bis 6, **dadurch gekennzeichnet, dass** die elektrische Versorgungsanordnung (23) für die Mittenelektrode (4) der Kerze (1) derart ausgelegt ist, dass die Dauer des elektrischen Bogens (17) einstellbar ist.

8. Vorrichtung zur Messung des Ionisationsstromes in einer Verbrennungskammer nach Anspruch 2, **dadurch gekennzeichnet, dass** die Antenne (12) nicht durch eine äußere Quelle polarisiert wird, sondern auf dem herrschenden veränderbaren Potential verbleibt.

## Claims

1. Device for measuring the ionisation current in a combustion chamber (3) of an internal combustion engine with spark ignition, of the type comprising a spark plug (1) having a central electrode (4) connected to electrical supply means (23) and inserted into a socket (2) by means of an insulator (5), and at least one antenna (12) entering said chamber (3) in the proximity of the spark plug (1), said antenna (12) cooperating with measuring means (15) and polarising means (22), **characterised in that** said polarising means (22) are configured to polarise said antenna (12) to a suitable positive electrical potential (26) such as to collect the current produced by the negative ionised components (21) present in the combustion chamber (3) and generated by the combustion of the carburised mixture initiated by releasing an electric arc (17) between the electrodes of the spark plug (1).

2. Device for measuring the ionisation current in a combustion chamber according to claim 1, **characterised in that** the electrical supply means (23) for the central electrode (4) of the spark plug (1) are configured to negatively polarise said central electrode (4).

3. Device for measuring the ionisation current in a combustion chamber according to claim 2, **characterised in that** the polarising means (22) for the antenna (12) are configured to polarise said antenna (12) to a positive electrical potential (26) of several tens of volts.

4. Device for measuring the ionisation current in a combustion chamber according to claim 1, **characterised in that** the electrical supply means (23) for the central electrode (4) of the spark plug (1) are configured to positively polarise said central electrode (4).

5. Device for measuring the ionisation current in a combustion chamber according to claim 4, **characterised in that** the polarising means (22) for the antenna (12) are configured to polarise said antenna (12) to a positive electrical potential (26) substantially greater than the substantially stable one of the central electrode (4) of the spark plug (1) following the arcing peak of the electric arc (17).

6. Device for measuring the ionisation current in a combustion chamber according to any one of claims 1 to 5, **characterised in that** the electrical supply means (23) for the central electrode (4) of the spark plug (1) are configured to continue to polarise said electrode (4) after the electric arc (17) has finished.

7. Device for measuring the ionisation current in a combustion chamber according to any one of claims 1 to 6, **characterised in that** the electrical supply means (23) for the central electrode (4) of the spark plug (1) are configured to control the duration of the electric arc (17).

8. Device for measuring the ionisation current in a combustion chamber according to claim 2, **characterised in that** the antenna (12) is not polarised by an external source, but left at floating potential.
